# EUROPEAN PATENT APPLICATION

(11) **EP 2 777 878 A1**
(43) Date of publication of application: **17.09.2014**
(21) Application number: 12848362.5
(22) Date of filing: 06.11.2012
(51) Int. Cl.: B24B 37/00, C09K 3/14, H01L 21/304

(54) **POLISHING COMPOSITION**

(30) Priority: 08.11.2011 JP 2011244912
(71) Applicant: Fujimi Incorporated, Kiyosu-shi, Aichi 452-8502 (JP)
(72) Inventor: MORINAGA, Hitoshi, Kiyosu-shi Aichi 452-8502 (JP); ASANO, Hiroshi, Kiyosu-shi Aichi 452-8502 (JP); SERIKAWA, Masayuki, Kiyosu-shi Aichi 452-8502 (JP)
(74) Representative: Grünecker, Kinkeldey, Stockmair & Schwanhäusser
(86) International application number: PCT/JP2012/078696
(87) International publication number: WO 2013/069623

(57) **Abstract**

A polishing composition containing at least water and silica and satisfying all of the following conditions (a) through (d) is provided. Condition (a) The specific surface area of the silica contained in the polishing composition is 30 m²/g or more. Condition (b) Silica having a particle size of 10 to 50 nm is contained in the amount of 2 % by mass or more. Condition (c) Silica having a particle size of 60 to 300 nm is contained in the amount of 2 % by mass or more. Condition (d) The value obtained by dividing the average particle size of the silica specified in the condition (c) by the average particle size of the silica specified in the condition (b) is 2 or more. If this polishing composition is used, a hard and brittle material substrate can be polished at high speed, and such polishing speed can be maintained for a long period of time even if this polishing composition is used repeatedly.

## Description

### TECHNICAL FIELD

The present invention relates to a polishing composition mainly for use in polishing objects to be polished composed of hard and brittle materials.

### BACKGROUND ART

In recent years, sapphire substrates have been employed for LED substrates and silicon carbide and silicon nitride substrates have been employed for power device substrates. These substrates are referred to as hard and brittle material substrates. The hard and brittle material substrate is required to be polished such that the surface thereof will become a supper-smooth surface.

Polishing is performed in a state where an object to be polished is pressed against a polishing pad, which has been pasted onto a platen of a polishing machine, under a predetermined pressure while supplying a polishing composition onto the polishing pad. Then, the polishing composition once used for polishing may be recovered and reused in some cases. Cyclic use of the polishing composition in this manner is useful to lessen environmental burden by decreasing an amount of the polishing composition discharged as waste fluid and to reduce the cost of polishing substrates by decreasing the amount of the polishing composition used. On the other hand, cyclic use of the polishing composition has involved the problem of gradually decreasing the polishing performance thereof and finally disabling the polishing composition. In addition, conventional polishing compositions also have a problem that a sufficient polishing rate cannot be attained.

In Patent Document 1, for example, polishing of sapphire substrates using a polishing composition containing colloidal silicon oxide in a relatively high concentration is disclosed. Patent Document 2 discloses polishing of integrated circuits (ICs) and the like by use of a polishing agent that contains spherical and discrete silica particles not linked to one another via bonds and in which the total set of particles has a bimodal particle size distribution. In those cases, however, it is difficult to attain a sufficient polishing rate. Additionally, cyclic use of such polishing compositions makes it difficult to control the capacity of polishing process at a constant level due to the gradually decreasing polishing rate, thereby resulting in reduced productivity of the hard and brittle material substrates. Moreover, since the polishing composition should be frequently exchanged, its consumption increases and thereby the production cost of the hard and brittle material substrates is raised.

### PRIOR ART DOCUMENTS

### Patent Documents

Patent Document 1: Japanese Laid-Open Patent Publication No. 2008-44078
Patent Document 2: Japanese National Phase Laid-Open Patent Publication No. 2003-529662

### SUMMARY OF THE INVENTION

### Problems that the Invention is to Solve

The objective of the present invention is to inexpensively provide a polishing composition capable of realizing a high polishing rate and capable of keeping the high polishing rate for a long period of time in cyclic use thereof.

### Means for Solving the Problems

To achieve the foregoing objective and in accordance with one aspect of the present invention, a polishing composition containing at least water and silica is provided, in which the composition satisfies all the following conditions:
(a) the specific surface area of the silica contained in the polishing composition is 30 m²/g or more;
(b) the polishing composition contains 2 % by mass or more of silica having a particle size of 10 to 50 nm;
(c) the polishing composition contains 2 % by mass or more of silica having a particle size of 60 to 300 nm; and
(d) a value obtained by dividing the average particle size of the silica specified in the condition (c) by the average particle size of the silica specified in the condition (b) is 2 or more.

### EFFECTS OF THE INVENTION

According to the polishing composition of the present invention, it is possible to realize a high polishing rate upon polishing hard and brittle material substrates and to keep the high polishing rate for a long period of time in cyclic use thereof.

### MODES FOR CARRYING OUT THE INVENTION

An embodiment of the present invention will be described below.

The polishing composition of the present embodiment contains at least water and silica and satisfies all the following conditions of (a) to (d):
(a) the specific surface area of the silica contained in the polishing composition is 30 m²/g or more;
(b) the polishing composition comprises 2 % by mass or more of silica having a particle size of 10 to 50 nm;
(c) the polishing composition comprises 2 % by mass or more of silica having a particle size of 60 to 300 nm; and
(d) the value obtained by dividing the average particle size of the silica specified in the condition (c) by the average particle size of the silica specified in the condition (b) is 2 or more.

The particle size, major axis and minor axis of the silica contained in the polishing composition are determined from a scanning electron microscope image of the silica using image analysis software or the like. The particle size of the silica can be obtained as a diameter of a circle having the same area as that of the particle of interest that is measured in the scanning electron microscope image. The average particle size of the silica is an average value of the particle sizes of the particles present within a visual field of the scanning electron microscope. The values of the major axis and minor axis of each particle can be obtained as lengths of the long side and the short side, respectively, of the minimum circumscribed rectangle for the scanning electron microscope image of the particle of interest.

The contents of the silica having a particle size of 10 to 50 nm (hereafter referred to as "Silica (b)") and the silica having a particle size of 60 to 300 nm (hereafter referred to as "Silica (c)") among the silica contained in the polishing composition are each 2 % by mass or more of the polishing composition. These contents can be obtained by calculating the percentages of Silica (b) and Silica (c), respectively, to the total silica contained in the polishing composition and by multiplying the total content of the silica in the polishing composition by these values. Preferably, the polishing composition contains 4 % by mass or more, more preferably 7 % by mass or more of each of Silica (b) and Silica (c).

Providing that B represents the average particle size of Silica (b) and C represents the average particle size of Silica (c) among the silica contained in the polishing composition, the value obtained by dividing C by B is preferably 2 or more, more preferably 2.5 or more, and still more preferably 3 or more. The larger the value obtained by dividing C by B is, the higher the attainable polishing rate becomes.

The percentage of Silica (c) to the total silica contained in the polishing composition is preferably 50 % by mass or more, still more preferably 60 % by mass or more. When the percentage of Silica (c) is within the range described above, a higher polishing rate can be obtained without increasing the total amount of the silica contained in the polishing composition. Therefore, the production cost of the polishing composition is reduced and also the residual silica on the surface of the substrates after polishing is decreased.

The upper limit of the silica content in the polishing composition is not particularly limited, but preferably 50 % by mass or less, and still more preferably 40 % by mass or less. The less the silica content is, the more the dispersion stability of the polishing composition is improved, and thus the polishing composition becomes easier to be handled. In addition, according to the present invention, a high polishing rate can be realized at a low silica content and the high polishing rate can be kept for a long period of time in cyclic use of the polishing composition. Accordingly, the polishing process can be performed inexpensively.

The specific surface area of the silica contained in the polishing composition is preferably 30 m²/g or more, and more preferably 40 m²/g or more. The larger the surface area of the silica contained in the polishing composition is, the longer period of time the polishing rate is kept for in cyclic use of the polishing composition. As used herein, the surface area of the silica refers to the area of the part of the silica which can actually contact with the surface of the hard and brittle material substrate. The specific surface area of the silica was calculated from the surface area calculated from the particle size of the silica and the number of particles in 1 g of the silica. Specifically, the particle size of each silica particle was obtained by using the scanning electron microscope, and then the surface area was calculated on the assumption that all the particles were perfect spheres. The specific surface area was calculated from the sum of the calculated surface areas and the number of particles in 1 g of the silica.

The upper limit of the specific surface area of the silica contained in the polishing composition is not particularly limited, but is preferably 2000 m²/g or less, still more preferably 1000 m²/g or less. The smaller the surface area of the silica is, the more the dispersion stability of the polishing composition is improved, and thus the polishing composition becomes easier to be handled.

The major axis of the silica particle contained in the polishing composition is preferably one and half times the minor axis thereof or less, and more preferably 1.3 times or less. The less the difference between the major axis and minor axis thereof is and the more spherical the silica is, the higher the polishing rate becomes.

The pH of the polishing composition is preferably 7.5 or more, and more preferably 7.8 or more. The pH of the polishing composition is also preferably 9.5 or less, and more preferably 9.2 or less. When the pH is within the range described above, the polishing rate and the dispersion stability of the abrasive grain are improved. In addition, the polishing composition can be handled safely.

The pH of the polishing composition is adjusted with known acids, bases, or salts thereof. Specifically, organic acids such as carboxylic acids, organic phosphonic acids, or organic sulfonic acids; inorganic acids such as phosphoric acid, phosphorous acid, sulfuric acid, nitric acid, hydrochloric acid, boric acid, or carbonic acid; organic bases such as amines and quaternary ammonium hydroxides; inorganic bases such as alkali metal hydroxides, alkaline earth metal hydroxides, or ammonia; or salts thereof are preferably employed.

In another aspect of the present invention, a method for polishing a hard and brittle material substrate using the polishing composition is provided. In still another aspect of the present invention, a method for manufacturing a hard and brittle material substrate including a step of polishing the hard and brittle material substrate using the polishing method is provided.

The polishing composition of the present embodiment has advantages described below.

The polishing composition of the present embodiment is capable of polishing objects to be polished composed of hard and brittle materials at a high polishing rate and capable of keeping the high polishing rate for a long period of time even when the polishing composition is subjected to cyclic use. Although the detailed mechanism of this effect has not been clarified, it is speculated as follows. Namely, it is speculated that when the silica having a particle size of 60 to 300 nm and silica having a particle size of 10 to 50 nm have proper average particle sizes and are contained in the polishing composition at proper contents, both of the silicas synergistically enhance the mechanical polishing activity thereof, thereby resulting in the significantly excellent polishing rate. In this case, it is preferred that the major silica, among all the silicas contained in the polishing composition, is the silica having a particle size of 60 to 300 nm which has a higher mechanical polishing activity. On the other hand, a solid phase reaction between the surface of the abrasive grains and that of the hard and brittle material substrate is also considered to contribute to a higher polishing rate. Therefore, it is speculated that inclusion of the silica having a sufficient surface area in the polishing composition leads to improved polishing performance durability, thereby keeping the polishing performance for longer period of time in cyclic use of the polishing composition. The present invention has successfully provided both the significantly excellent polishing rate and sufficiently durable polishing performance in cyclic use of the polishing composition by including proper amounts of silica having a particle size of 60 to 300 and silica having a particle size of 10 to 50 nm in the polishing composition and ensuring the certain levels of the silica surface areas. The conventional polishing compositions do not exhibit these characteristics. In this respect, the present invention is distinct from the prior arts.

The polishing composition can be used in an apparatus and under conditions that have been usually employed for polishing of hard and brittle material substrates. Single-side polishing apparatuses and double-side polishing apparatuses are typically employed as the polishing apparatus. In the single-side polishing apparatus, the substrate is held with a holding tool, which is referred to as a carrier, a platen on which a polishing pad has been pasted is pressed against the single surface of the substrate, and then the platen is rotated while supplying the polishing composition to polish the single surface of the substrate. In the double-side polishing apparatus, the substrate is held with the carrier, platens on which polishing pads have been pasted are pressed against the both surfaces of the substrate, and then the platens are rotated in opposite directions while supplying the polishing composition from the upper side to polish both surfaces of the substrate. During polishing, the substrate is polished by a physical action due to the friction between the polishing pad together with the polishing composition and the substrate and a chemical action to the substrate given by the polishing composition.

The polishing conditions include the polishing load. Generally, the larger the polishing load is, the higher the friction force between the abrasive grain and substrate becomes. Consequently, the higher polishing load enhances the mechanical processability to increase the polishing rate. The polishing load applied to the substrate is not particularly limited, but is preferably 50 to 1,000 g/cm², more preferably 100 to 800 g/cm², and still more preferably 300 to 600 g/cm². When the polishing load is within the above range, the sufficiently high polishing rate can be attained, and additionally, wafer damage and generation of surface defects can be reduced.

The polishing conditions also include the linear velocity. The linear velocity is generally affected by the number of revolutions of the polishing pad, the number of revolutions of the carrier, dimensions of the substrate, the number of the substrates, and the like. As the higher linear velocity leads to an increased friction force applied to the substrate, the mechanical polishing action on the substrate is enhanced. In addition, the heat generated by the friction may enhance the chemical polishing activity of the polishing composition. The linear velocity is not particularly limited, but preferably 10 to 300 m/min, and more preferably 30 to 200 m/min. When the linear velocity is within the above range, the sufficiently high polishing rate can be attained, and additionally, the proper friction force can be applied to the substrate,

The polishing pad is not limited by material, thickness, or physical properties such as hardness. Any polishing pad, e.g., a polyurethane type, non-woven fabric type or suede type with various hardness and thickness, polishing pads containing abrasive grain, polishing pads without abrasive grain, or the like, can be employed.

The polishing composition described above can be recovered and reused for polishing after it has been once used for polishing the hard and brittle material substrates. An example of methods for reusing the polishing composition includes a method in which a used polishing composition discharged from a polishing apparatus is temporarily recovered in a tank and then recycled into the polishing apparatus to be reused. Cyclic use of the polishing composition reduces the amount of discharge of the polishing composition as waste fluid and consumption of the polishing composition. This is useful regarding lessening of environmental burden and reduction of the production cost for the hard and brittle material substrates.

Components in the polishing composition such as silica are consumed and lost by polishing in cyclic use of the polishing composition. Thus, the components such as silica may be supplemented with the amounts corresponding to losses thereof to the polishing composition under cyclic use. The components to be supplied may be added individually to the polishing composition, or alternatively, added as a mixture containing two or more components in any concentrations to the polishing composition. In this case, the polishing composition is adjusted to a suitable state for reuse and the polishing performance thereof is suitably maintained.

The polishing conditions include the supply rate of the polishing composition. The supply rate of the polishing composition depends on the type of the substrate, the type of the polishing apparatus and other polishing conditions, but is preferably a rate sufficient enough for the polishing composition to be uniformly supplied to the whole parts of the substrate and polishing pad.

The objects to be effectively polished according to the present invention are hard and brittle materials. More effective objects to be polished are sapphire, silicon carbide and silicon nitride, and among others, sapphire is effectively polished.

The embodiment may be modified as follows.

The polishing composition may contain an abrasive grain other than silica. Examples of the other abrasive grains include, for example, alumina, zirconia, ceria, titanium oxide, and the like. It is preferable; however, that the percentage of the other abrasive grain in the polishing composition is low and it is more preferable that abrasive grain other than silica is not substantially contained in the polishing composition.

The polishing composition may contain additives having a function to further enhance the polishing rate such as complexing agents, etching agents and oxidizing agents as necessary.

The polishing composition may further contain known additives such as preservatives, antifungal agents and rust preventives as necessary.

The polishing composition may further contain additives such as dispersing agents to improve the abrasive grain dispersion and dispersing auxiliaries to ease redispersion of the aggregates as necessary.

The polishing composition may be of one-component type or multi-component type, i.e., two or more-component type. In addition, when a polishing apparatus equipped with a plurality of supplying paths for the polishing agent is used, two or more compositions may be previously prepared and thereafter mixed within the polishing apparatus to form the polishing composition.

The polishing composition may be prepared by diluting a stock solution of the polishing composition with water. When the polishing composition is of two-composition type, the order of mixing and diluting both of the compositions may be changed arbitrarily. For example, one composition may be diluted with water, followed by mixing the dilution with the other composition, both of the compositions may be mixed together and diluted with water simultaneously, or alternatively, both of the compositions may be mixed together, followed by diluting the mixture with water.

Examples and Comparative Examples of the present invention will be illustrated below.

### Examples 1-10 and Comparative Examples 1-4

Silicas having various particle sizes were mixed together at the contents shown in Table 2 and pH values were adjusted to prepare the polishing compositions of Examples 1-10 and Comparative Examples 1-4, of which abrasive grain surface areas were different from each other. As the silica, spherical colloidal silica having a major axis 1.1 times the minor axis thereof was used. Nitric acid and potassium hydroxide were used as pH adjusters. Three pieces of sapphire substrate (C surface) were polished simultaneously using each of polishing compositions of Examples and Comparative Examples under the conditions shown in Table 1. All of the sapphire substrates used were circular with a diameter of 50.8 mm (2 inches). The polishing compositions having a total volume of 500 ml was used for polishing while being circulated at the supply rate shown in Table 1.

The average particle size B and content of Silica (b) having a particle size of 10 to 50 nm contained in each polishing composition, average particle size C and content of Silica (c) having a particle size of 60 to 300 nm contained in each polishing composition, value (C/B) obtained by dividing the average particle size C of Silica (c) by the average particle size B of Silica (b), specific surface area of the silica contained in the polishing compositions, and pH are as shown in Table 2. The average particle size, major axis and minor axis of the silica particle were determined from the scanning electron microscope images of the silica of interest using image analysis software. Measurements were performed for total of 200 silica particles selected from 10 visual fields of the scanning electron microscope (20 silica particles per visual field). In addition, in order to calculate the polishing rate for each polishing composition, the sapphire substrates were weighed before and after polishing. The polishing rate calculated from the weight difference of the substrate between before and after polishing is shown in the column "Polishing rate" in Table 2. An index for polishing performance durability in cyclic use of the polishing composition was calculated as follows. When the polishing rate was decreased by more than 10% comparing with the polishing rate immediately after start of polishing, polishing of the sapphire substrate was stopped, and then the total polished amount per sapphire substrate was determined. Then, the total polished amount was divided by the silica content in the polishing composition. The obtained value is shown in the column "Total polished amount/silica content" in Table 2 as the index for polishing performance durability. In addition, the degree of decreased polishing rate in cyclic use of the polishing composition was confirmed by calculating the polishing rate every 30 minutes in the aforementioned manner in cyclic use of the identical polishing composition in polishing.

**Table 1**

| <Sapphire substrate polishing conditions> | | |
|---|---|---|
| Polishing machine | Single side polisher "EJ-380IN" (surface plate diameter of 380 mm) made by Engis Japan Corporation | |
| Polishing pad | Non-woven fabric polishing pad "SUBA800" made by Nitta Haas Incorporated | |
| Polishing pressure | | 300 g/cm² (29 4 kPa) |
| Surface plate rotational rate | | 110 rpm |
| Linear velocity | | 76 m/min |
| Polishing composition feed rate | | 100 mL/min |

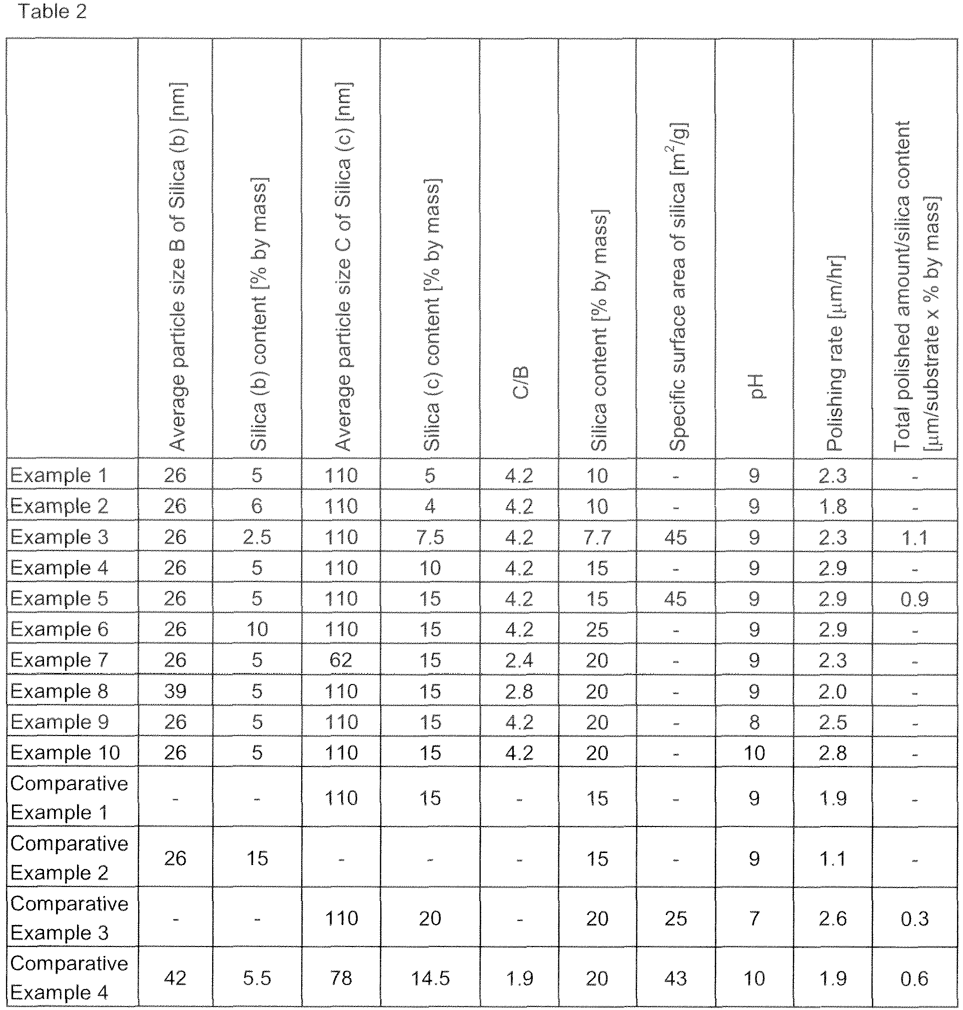

As shown in Table 2, when hard and brittle materials were polished using the polishing compositions of Examples 1-10, high polishing rates were attained and the high polishing rates were kept for long periods of time in cyclic use of the polishing compositions. Furthermore, such polishing performance was able to be realized with less content of silica.

## Claims

1. A polishing composition comprising at least water and silica, **characterized in that** the composition satisfies all the following conditions:
(a) the specific surface area of the silica contained in the polishing composition is 30 m²/g or more;
(b) the polishing composition contains 2 % by mass or more of silica having a particle size of 10 to 50 nm;
(c) the polishing composition contains 2 % by mass or more of silica having a particle size of 60 to 300 nm; and
(d) a value obtained by dividing the average particle size of the silica specified in the condition (c) by the average particle size of the silica specified in the condition (b) is 2 or more.

2. The polishing composition according to claim 1, **characterized in that** the content of the silica specified in the condition (b) and the content of the silica specified in the condition (c) are each 4 % by mass or more.

3. The polishing composition according to claim 1 or 2, **characterized in that** the percentage of the silica specified in the condition (c) to the total silica contained in the polishing composition is 50 % by mass or more.

4. The polishing composition according to any one of claims 1 to 3, **characterized in that** the polishing composition has a pH of 7.5 to 9.5.

5. The polishing composition according to any one of claims 1 to 4, **characterized in that** the content of the silica specified in condition the (b) and the content of the silica specified in the condition (c) are each 7 % by mass or more.

6. A method for polishing a hard and brittle material substrate, comprising polishing the hard and brittle material substrate using the polishing composition according to any one of claims 1 to 5.

7. A method for manufacturing a hard and brittle material substrate, comprising a step of polishing the hard and brittle material substrate using the method according to claim 6.
